# EUROPEAN PATENT APPLICATION

(11) **EP 4 379 774 A1**
(43) Date of publication of application: **05.06.2024**
(21) Application number: 22849106.4
(22) Date of filing: 27.06.2022
(51) Int. Cl.: H01L 21/20, H01L 21/263, H01L 21/322, H01L 21/338, H01L 29/778, H01L 29/812

(54) **SUBSTRATE FOR SEMICONDUCTOR DEVICES AND METHOD FOR PRODUCING SAME**

(30) Priority: 29.07.2021 JP 2021124488
(71) Applicant: Shin-Etsu Handotai Co., Ltd., Tokyo 100-0004 (JP)
(72) Inventor: HAGIMOTO Kazunori, Annaka-shi, Gunma 379-0196 (JP)
(74) Representative: Mooser, Sebastian Thomas
(86) International application number: PCT/JP2022/025496
(87) International publication number: WO 2023/008034

(57) **Abstract**

The present invention is a substrate for a semiconductor device, including: a high-resistant silicon single crystal substrate having a resistivity of 100 Ω·cm or more; a first buffer layer composed of an AlN layer and formed on the high-resistant silicon single crystal substrate; and a nitride semiconductor layer provided on the first buffer layer, wherein there is no low-resistivity portion on a top surface of the high-resistant silicon single crystal substrate, the low-resistivity portion having a resistivity relatively lower than the resistivity of an entirety of the high-resistant silicon single crystal substrate. This provides: a substrate for a semiconductor device that can impart good electric characteristics to a device; and a simple method for manufacturing such a substrate.

## Description

### TECHNICAL FIELD

The present invention relates to a substrate for a semiconductor device and a method for manufacturing the same.

### BACKGROUND ART

Epitaxial substrates using a nitride semiconductor are used for power devices that operate with high frequency and high output. Specifically, as power devices suitable for amplification within a high-frequency region such as microwave, sub-millimeter wave, and millimeter wave, a high electron mobility transistor (HEMT) is known, for example.

For example, Patent Document 1 discloses an epitaxial substrate used for such an HEMT, etc. The epitaxial substrate is composed of, for example: a buffer layer composed of an AlN layer on a silicon substrate, an AlGaN layer, and a superlattice structure in which GaN layers and AlN layers are alternately laminated; and thereon, a device active layer in which a channel layer composed of GaN, a barrier layer composed of AlGaN, and a cap layer composed of GaN are formed. On the epitaxial substrate, a source electrode, a drain electrode, and a gate electrode are provided to obtain a semiconductor element (for example, the HEMT, etc.)

### CITATION LIST

### PATENT LITERATURE

Patent Document 1: JP 2010-225703 A

### SUMMARY OF INVENTION

### TECHNICAL PROBLEM

However, when the silicon substrate is a high-resistant silicon substrate in an epitaxial substrate with the above structure, Al is diffused from the AlN layer into the high-resistant silicon substrate to form a low-resistant layer in the high-resistant silicon substrate, and current flows through this portion as a leak path in the horizontal direction, which deteriorates electric characteristics of the device.

The present invention has been made to solve the above problem. An object of the present invention is to provide a substrate for a semiconductor device that can impart good electric characteristics to a device, and a simple method for manufacturing such a substrate.

### SOLUTION TO PROBLEM

To solve the above problem, the present invention provides a substrate for a semiconductor device, comprising:
a high-resistant silicon single crystal substrate having a resistivity of 100 Ω·cm or more;
a first buffer layer composed of an AlN layer and formed on the high-resistant silicon single crystal substrate; and
a nitride semiconductor layer provided on the first buffer layer,
wherein there is no low-resistivity portion on a top surface of the high-resistant silicon single crystal substrate, the low-resistivity portion having a resistivity relatively lower than the resistivity of an entirety of the high-resistant silicon single crystal substrate.

A semiconductor device having good high-frequency characteristics can be manufactured with such a substrate for a semiconductor device in which the low-resistivity portion is absent in the high-resistant silicon substrate having a resistivity of 100 Ω·cm or more.

The nitride semiconductor layer provided on the first buffer layer is preferably:
a second buffer layer composed of a nitride semiconductor layer provided on the first buffer layer; and
a device active layer composed of a nitride semiconductor layer provided on the second buffer layer.

Particularly in the present invention, the substrate is preferably a substrate for a semiconductor device having such a structure.

In addition, the present invention also provides a method for manufacturing a substrate for a semiconductor device, the method comprising steps of:
(1) preparing a laminated substrate including: a high-resistant silicon single crystal substrate having a resistivity of 100 Ω·cm or more; a first buffer layer composed of an AlN layer and formed on a top surface of the high-resistant silicon single crystal substrate; and a nitride semiconductor layer provided on the first buffer layer; and
(2) irradiating the laminated substrate with electron beam from a rear surface side of the high-resistant silicon single crystal substrate to erase a low-resistivity portion formed on a top surface of the high-resistant silicon single crystal substrate, the low-resistivity portion having a resistivity relatively lower than the resistivity of an entirety of the high-resistant silicon single crystal substrate.

With such a manufacturing method, the low-resistivity portion formed on the top surface of the high-resistant silicon single crystal substrate can be relatively easily erased, and the substrate for a semiconductor device with which a semiconductor device having good high-frequency characteristics can be manufactured can be manufactured.

The nitride semiconductor layer provided on the first buffer layer is preferably:
a second buffer layer composed of a nitride semiconductor layer provided on the first buffer layer; and
a device active layer composed of a nitride semiconductor layer provided on the second buffer layer.

Particularly in the present invention, the substrate is preferably a substrate for a semiconductor device having such a structure.

### ADVANTAGEOUS EFFECTS OF INVENTION

As noted above, the present invention can provide a substrate for a semiconductor device that can impart good electric characteristics to a device by erasing the low-resistivity portion formed on the top surface of the high-resistant silicon single crystal substrate and a simple method for manufacturing such a substrate.

### BRIEF DESCRIPTION OF DRAWINGS

FIG. 1 is a schematic view illustrating an example of a method for manufacturing the inventive substrate for a semiconductor device.
FIG. 2 is an image of a CPW electrode formed on a substrate for a semiconductor device in Example.
FIG. 3 shows results of SNDM measurement of cross sections of substrates for a semiconductor device produced in Example and Comparative Example.
FIG. 4 shows a result of a diffusion state of Al toward a Si wafer in the substrate for a semiconductor device produced in Comparative Example, the result being measured by backside SIMS.
FIG. 5 is measurement results of second harmonic of the substrates for a semiconductor device produced in Example and Comparative Example.

### DESCRIPTION OF EMBODIMENTS

As noted above, the epitaxial substrate having a HEMT structure has a problem of deterioration of electric characteristics of a device due to diffusion of Al in the first buffer layer composed of the AlN layer toward the top surface of the high-resistant silicon substrate to form a low-resistant layer. For example, when an n-type silicon single crystal substrate is used as a high-resistant silicon substrate, Al in the first buffer layer composed of the AlN layer diffuses toward the top surface of the n-type silicon single crystal substrate to form a P-channel and deteriorate electric characteristics of a device.

The present inventor has made earnest study to solve the above problem, and found that the substrate for a semiconductor device in which the AlN layer is laminated on the top surface of the n-type silicon single crystal substrate is irradiated with electron beam from the rear surface side of the n-type silicon single crystal substrate, and thereby the P-channel generated due to diffusion of Al can be erased. This finding has led to complete the present invention.

Specifically, the present invention is a substrate for a semiconductor device, comprising: a high-resistant silicon single crystal substrate having a resistivity of 100 Ω·cm or more; a first buffer layer composed of an AlN layer and formed on the high-resistant silicon single crystal substrate; and a nitride semiconductor layer provided on the first buffer layer, wherein there is no low-resistivity portion on a top surface of the high-resistant silicon single crystal substrate, the low-resistivity portion having a resistivity relatively lower than the resistivity of an entirety of the high-resistant silicon single crystal substrate.

In addition, the present invention is a method for manufacturing a substrate for a semiconductor device, the method comprising steps of: (1) preparing a laminated substrate including: a high-resistant silicon single crystal substrate having a resistivity of 100 Ω·cm or more; a first buffer layer composed of an AlN layer and formed on a top surface of the high-resistant silicon single crystal substrate; and a nitride semiconductor layer provided on the first buffer layer; and (2) irradiating the laminated substrate with electron beam from a rear surface side of the high-resistant silicon single crystal substrate to erase a low-resistivity portion formed on a top surface of the high-resistant silicon single crystal substrate, the low-resistivity portion having a resistivity relatively lower than the resistivity of an entirety of the high-resistant silicon single crystal substrate.

Hereinafter, the present invention will be described in detail, but the present invention is not limited thereto.

### [Substrate for Semiconductor Device]

The inventive substrate for a semiconductor device is a substrate for a semiconductor device comprising: a high-resistant silicon single crystal substrate having a resistivity of 100 Ω·cm or more; a first buffer layer composed of an AlN layer and formed on the high-resistant silicon single crystal substrate; and a nitride semiconductor layer provided on the first buffer layer, wherein there is no low-resistivity portion on the high-resistant silicon single crystal substrate.

The nitride semiconductor layer provided on the first buffer layer is not particularly limited, but preferably: a second buffer layer composed of a nitride semiconductor layer provided on the first buffer layer; and a device active layer composed of a nitride semiconductor layer provided on the second buffer layer, for example.

In a conventional substrate for a semiconductor device in which an AlN layer is laminated on a high-resistant silicon single crystal substrate, a low-resistivity portion derived from Al diffused from the AlN layer is present on the top surface of the high-resistant silicon single crystal substrate. For example, when the high-resistant silicon single crystal substrate is an n-type silicon single crystal substrate, the diffused Al forms a P-channel, which is originally absent, on the top surface of the n-type silicon single crystal substrate to decrease the resistivity of the top surface. Also, when the high-resistant silicon single crystal substrate is a p-type silicon single crystal substrate, the diffused Al increases p-type dopants on the top surface of the p-type silicon single crystal substrate to decrease the resistivity of the top surface. As above, the conventional substrate for a semiconductor device has a problem of deterioration of electric characteristics of a device due to the P-channel caused by Al diffused from the AlN layer.

Meanwhile, in the inventive substrate for a semiconductor device, the low-resistivity portion having a resistivity relatively lower than the resistivity of the entirety of the high-resistant silicon single crystal substrate is absent on the top surface of the high-resistant silicon single crystal substrate, and thereby good electric characteristics can be imparted to a device. In the inventive substrate for a semiconductor device, the high-resistant silicon single crystal substrate may be any of n-type and p-type.

In the present invention, the high-resistant silicon single crystal substrate has "top surface" and "rear surface". The "top surface" refers to a surface on the side on which the first buffer layer composed of the AlN layer is to be formed. The "rear surface" refers to the surface opposite to the surface on which the first buffer layer is to be formed.

### [Method for Manufacturing Substrate for Semiconductor Device]

The inventive substrate for a semiconductor device can be easily manufactured by the inventive method for manufacturing a substrate for a semiconductor device. The inventive method for manufacturing a substrate for a semiconductor device comprises steps of:
(1) preparing a laminated substrate including: a high-resistant silicon single crystal substrate having a resistivity of 100 Ω·cm or more; a first buffer layer composed of an AlN layer and formed on a top surface of the high-resistant silicon single crystal substrate; and a nitride semiconductor layer provided on the first buffer layer; and
(2) irradiating the laminated substrate with electron beam from a rear surface side of the high-resistant silicon single crystal substrate to erase a low-resistivity portion formed on a top surface of the high-resistant silicon single crystal substrate, the low-resistivity portion having a resistivity relatively lower than the resistivity of an entirety of the high-resistant silicon single crystal substrate.

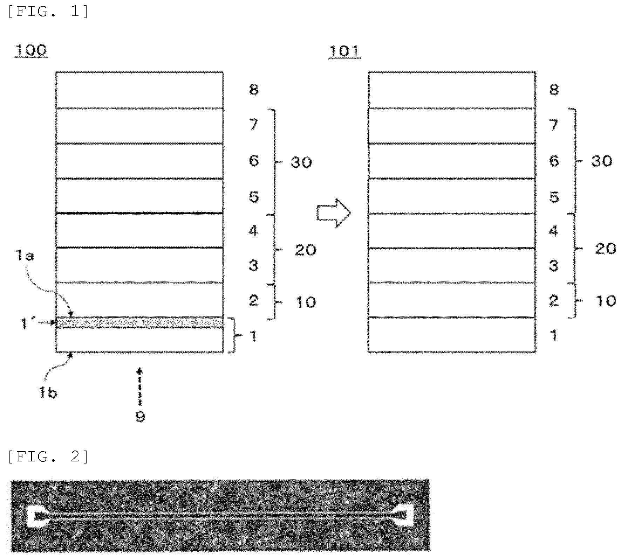

Hereinafter, the inventive method for manufacturing a substrate for a semiconductor device will be specifically described by using FIG. 1 with exemplifying a case where the high-resistant silicon single crystal substrate is an n-type silicon single crystal substrate, but the inventive method for manufacturing a substrate for a semiconductor device can be performed also in a case of a p-type silicon single crystal substrate. The structure of the following substrate for a semiconductor device is an example, and not limited thereto.

### <Step (1)>

First, an n-type silicon single crystal substrate 1 is prepared. The prepared substrate is not particularly limited as long as it is a high-resistant n-type silicon single crystal substrate having a resistivity of 100 Ω·cm or more, and may be a substrate having, for example, a diameter of 100 to 300 mm, P-, Sb-, or As-doped, FZ single crystal, orientation <111>, and a resistivity of 100 Ω·cm to 3000 Ω·cm. In the case of the p-type silicon single crystal substrate, the dopant may be B, Al, or Ga, for example.

Then, a first buffer layer 10 composed of an AlN layer 2 is formed on the top surface 1a of the n-type silicon single crystal substrate 1. The thickness of the AlN layer 2 is not particularly limited, but may be, for example 20 to 500 nm, more preferably 50 to 300 nm, further preferably 100 to 200 nm, and may be particularly 150 nm.

Then, a nitride semiconductor layer is formed on the first buffer layer 10. The nitride semiconductor layer is not particularly limited, but preferably: a second buffer layer 20 composed of a nitride semiconductor layer provided on the first buffer layer 10; and a device active layer 30 composed of a nitride semiconductor layer provided on the second buffer layer 20, for example.

As the second buffer layer 20 formed on the first buffer layer 10, an AlGaN layer 3 having a thickness of, for example, 20 to 500 nm, more preferably 50 to 300 nm, further preferably 100 to 200 nm, particularly 160 nm may be formed, and on the AlGaN layer 3, a superlattice layer (SLs (GaN/AlN)) 4 in which GaN layers and AlN layers are alternately laminated with, for example, 10 to 120 pairs, preferably 50 to 100 pairs, particularly 70 pairs may be formed.

As the device active layer 30 formed on the second buffer layer 20, a GaN layer 5 having a thickness of, for example, 100 to 2000 nm, preferably 400 to 1200 nm, more preferably 600 to 1000 nm, particularly 800 nm may be formed, an AlGaN layer 6 having a thickness of, for example, 5 to 100 nm, preferably 10 to 50 nm, more preferably 20 to 30 nm, particularly 25 nm may be formed thereon, and a GaN layer 7 having a thickness of, for example, 1 to 10 nm, preferably 1 to 5 nm, particularly 3 nm, may be further formed thereon.

An electrode 8 may be further formed thereon.

As above, prepared is a laminated substrate 100 having: the n-type silicon single crystal substrate 1; the first buffer layer 10 composed of the AlN layer 2; and the nitride semiconductor layer (the second buffer layer 20 and the device active layer 30). In the laminated substrate 100 prepared here, a region where a P-channel is present (a low-resistivity portion) 1' is formed in a region near the top surface 1a of the n-type silicon single crystal substrate 1 by Al in the AlN layer 2 diffusing toward the n-type silicon single crystal substrate 1. When the p-type silicon single crystal substrate is used, the low-resistivity portion is a region having a relatively high concentration of the p-type dopant compared with the entirety of the p-type silicon single crystal substrate.

### <Step (2)>

Then, the laminated substrate 100 prepared in the step (1) is irradiated with electron beam 9 from the rear surface 1b side of the n-type silicon single crystal substrate 1 to erase the P-channel formed on the top surface 1a of the n-type silicon single crystal substrate 1 and manufacture the inventive substrate 101 for a semiconductor device without the region 1' where the P-channel is present. When the p-type silicon single crystal substrate is used, excessive P-channel in the low-resistivity portion on the top surface is erased by electron beam irradiation to set the P-channel concentration on the top surface to be equivalent to or less than that of the entire substrate and manufacture the inventive substrate for a semiconductor device.

The irradiation conditions of electron beam in this time may be appropriately selected. The irradiation energy may be, for example, 300 to 5000 KeV, preferably 1 to 3 MeV, and particularly 2 MeV. The irradiation dose may be, for example, 1×10¹⁴ /cm² or more and 1×10¹⁶ /cm² or less, and preferably 5×10¹⁴ /cm² or more and 5×10¹⁵ /cm² or less. In particular, the irradiation conditions are preferably 2 MeV and 1×10¹⁴ /cm² or more and 1×10¹⁶ /cm² or less.

A method for checking presence or absence of the P-channel on the top surface 1a of the n-type silicon single crystal substrate 1 is not particularly limited, and scanning nonlinear dielectric microscopy (SNDM) may be used, for example.

Specifically, whether the low-resistivity portion is present or not on the top surface of the high-resistant silicon single crystal substrate can be checked by SNDM measurement. For example, in the case of the n-type silicon single crystal substrate, a signal derived from the P-channel appears on the substrate top surface when the low-resistivity portion is present, and a signal derived from the P-channel does not appear when the low-resistivity portion is absent.

With the inventive method for manufacturing a substrate for a semiconductor device as above, the low-resistivity portion formed on the top surface of the high-resistant silicon substrate can be erased by a simple method to manufacture a substrate for a semiconductor device that can impart good electric characteristics to a semiconductor device.

### EXAMPLE

Hereinafter, the present invention will be specifically described with reference to Example and Comparative Example, but the present invention is not limited thereto.

### (Example)

On the top surface of an n-type silicon single crystal substrate (diameter: 150 mm, FZ single crystal, P-dope, orientation <111>, resistivity: 100 Ω·cm or more), an AlN layer having a thickness of 150 nm was formed, an AlGaN layer having a thickness of 160 nm was formed thereon, and a superlattice layer in which GaN layers and AlN layers were alternately laminated with 70 pairs was further formed. Then, a GaN layer having a thickness of 800 nm was formed, an AlGaN layer having a thickness of 25 nm was formed thereon, and a GaN layer having a thickness of 3 nm was further formed. Then, the laminated substrate epitaxially grown as above was taken out of the manufacturing apparatus, and a CPW electrode (A1) as shown in FIG. 2 was formed (L = 2199 um) by a photolithographic process.

Then, the n-type silicon single crystal substrate of the laminated substrate was irradiated with electron beam with 2 MeV and 1×10¹⁵ /cm² from the rear surface side thereof by using an apparatus by Nissin Electric Co., Ltd. (3000-kV apparatus, NHV Corporation) to produce a substrate for a semiconductor device.

### (Comparative Example)

A substrate for a semiconductor device was manufactured under the same conditions as of Example except that the electron beam irradiation was not performed.

### (Evaluation of Presence/Absence of P-Channel)

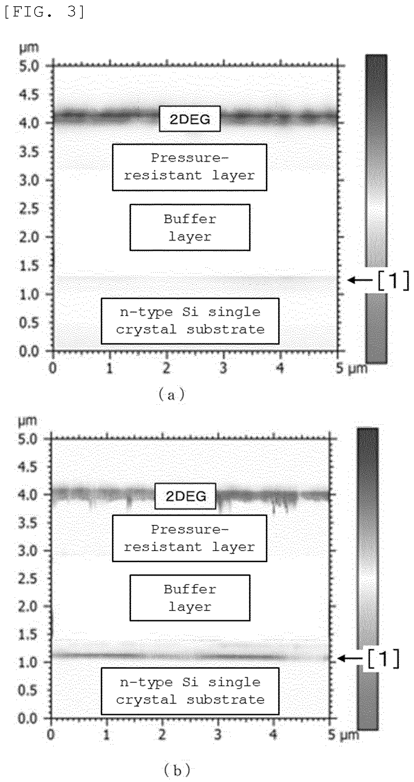

With each of the substrates for a semiconductor device manufactured in Example and Comparative Example, a chip was taken from a part of the sample with a CPW electrode, and the cross section was visualized by a scanning nonlinear dielectric microscope (SNDM). FIG. 3 shows the results. In FIG. 3, (a) shows the result of Example, and (b) shows the result of Comparative Example. In FIG. 3, 2DEG represents a two-dimensional electron gas, and the pressure-resistant layer is a high-resistant layer doped with carbon. This is a layer for preventing an input signal from exiting to the substrate side.

In Example, which performed the electron beam irradiation, only a weak signal (blue signal) derived from the n-type silicon single crystal substrate itself appears in the position represented by [1] in FIG. 3(a) (near the interface between the n-type Si single crystal substrate and the buffer layer), and a signal derived from the P-channel (red signal) does not appear. Accordingly, it has been confirmed that, in the present invention, the P-channel (low-resistivity portion) generated on the top surface of the n-type Si single crystal substrate can be erased by the electron beam irradiation.

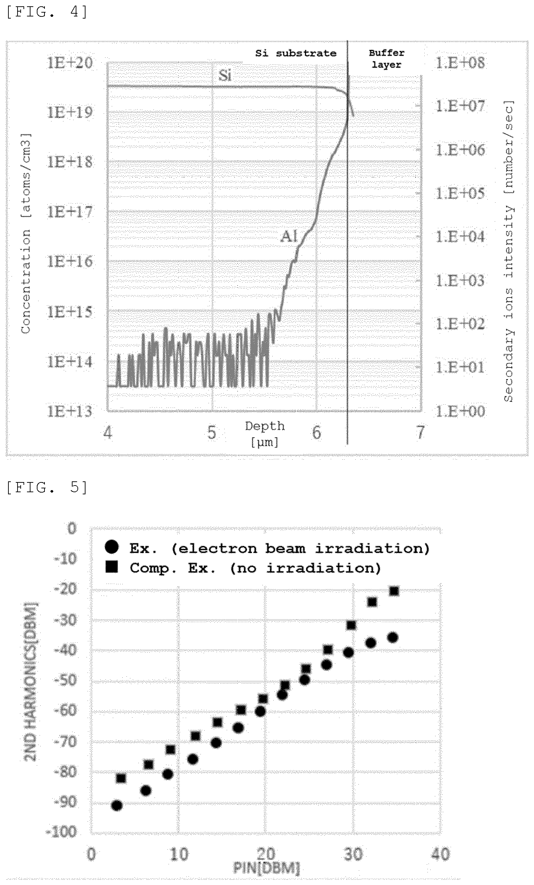

In Comparative Example, which did not perform the electron beam irradiation, a signal derived from the P-channel (red signal) intensely appears in the position represented by [1] in FIG. 3(b). FIG. 4 shows the investigation results of diffusion of Al toward the silicon single crystal substrate by backside SIMS. As shown, it is found that the P-channel (low-resistivity portion) is present on the top surface of the silicon single crystal substrate when the electron beam irradiation is not performed.

### (Evaluation of High-Frequency Characteristics)

Measured were high-frequency characteristics of each of the substrates for a semiconductor device manufactured in Example and Comparative Example. FIG. 5 shows the results. It is obviously found from FIG. 5 that Example in which the P-channel is erased by the electron beam irradiation improves second harmonic compared with Comparative Example in which the P-channel is present.

As above, it has been revealed that the present invention can erase the low-resistivity portion generated on the top surface of the high-resistant silicon single crystal substrate of the substrate for a semiconductor device by the electron beam irradiation to impart good electric characteristics to a device.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A substrate for a semiconductor device, comprising:
a high-resistant silicon single crystal substrate having a resistivity of 100 Ω·cm or more;
a first buffer layer composed of an AlN layer and formed on the high-resistant silicon single crystal substrate; and
a nitride semiconductor layer provided on the first buffer layer,
wherein there is no low-resistivity portion on a top surface of the high-resistant silicon single crystal substrate, the low-resistivity portion having a resistivity relatively lower than the resistivity of an entirety of the high-resistant silicon single crystal substrate.

2. The substrate for a semiconductor device according to claim 1, wherein the nitride semiconductor layer provided on the first buffer layer is:
a second buffer layer composed of a nitride semiconductor layer provided on the first buffer layer; and
a device active layer composed of a nitride semiconductor layer provided on the second buffer layer.

3. A method for manufacturing a substrate for a semiconductor device, the method comprising steps of:
(1) preparing a laminated substrate including: a high-resistant silicon single crystal substrate having a resistivity of 100 Ω·cm or more; a first buffer layer composed of an AlN layer and formed on a top surface of the high-resistant silicon single crystal substrate; and a nitride semiconductor layer provided on the first buffer layer; and
(2) irradiating the laminated substrate with electron beam from a rear surface side of the high-resistant silicon single crystal substrate to erase a low-resistivity portion formed on a top surface of the high-resistant silicon single crystal substrate, the low-resistivity portion having a resistivity relatively lower than the resistivity of an entirety of the high-resistant silicon single crystal substrate.

4. The method for manufacturing a substrate for a semiconductor device according to claim 3, wherein the nitride semiconductor layer provided on the first buffer layer is:
a second buffer layer composed of a nitride semiconductor layer provided on the first buffer layer; and
a device active layer composed of a nitride semiconductor layer provided on the second buffer layer.
